# FASCICULE DE BREVET EUROPEEN

(11) **EP 0 770 430 B1**
(45) Date de publication et mention de la délivrance du brevet: **17.11.1999**
(21) Numéro de dépôt: 96402226.3
(22) Date de dépôt: 18.10.1996
(51) Int. Cl.: B06B 1/02

(54) **Procédé et dispositif de pilotage d'actionneurs à ultra-sons de puissance**
Verfahren und Vorrichtung zur Ansteuerung von Leistungs-Ultraschallgebern
Process and device for driving ultrasonic power transducers

(30) Priorité: 27.10.1995 FR 9512900
(43) Date de publication de la demande: 02.05.1997
(73) Titulaire: SOLLAC S.A., 92800 Puteaux (FR); ASCOMETAL (Société anonyme), F-92800 Puteaux (FR)
(72) Inventeur: Alexandre, Patrick, 57000 Metz (FR); Nogues, Michel, 78510 Triel s/Seine (FR); Claessen, Pierre, 78124 Mareil s/Mauldre (FR); Joannes, Guy, 78920 Ecqueville (FR)
(74) Mandataire: Ventavoli, Roger

(56) Documents cités:
- EP-A- 0 217 694
- EP-A- 0 359 217
- EP-A- 0 662 356

## Description

La présente invention concerne l'utilisation des ultra-sons de puissance, et plus particulièrement le pilotage des éléments générateurs de ces ultra-sons, ou actionneurs, qui sont utilisés pour créer des vibrations à fréquence ultra-sonore dans des dispositifs ou appareils divers.

Certaines applications des ultra-sons de puissance sont largement développées, par exemple pour le nettoyage ou le dégraissage de pièces diverses, la vaisselle par exemple. D'autres applications, par exemple dans l'industrie sidérurgique, sont en cours de développement, par exemple en assistance des bains acide de décapage, ou en assistance des solvants de dégraissage,pour améliorer la lubrification en coulée continue ou en tréfilage, ou encore pour favoriser la précipitation des mattes dans les bains de galvanisation.

Les actionneurs ou transducteurs utilisés pour générer les ultra-sons sont classiquement des pastilles piézoélectriques alimentées par des générateurs électriques de puissance sous une fréquence prédéterminée.

Pour être efficaces dans chaque application, ces actionneurs doivent fonctionner à une fréquence nominale, ou dans une gamme de fréquences réduite, adaptée à chaque application.

Par ailleurs, pour optimiser les performances globales de la chaîne acoustique, c'est à dire pour avoir le meilleur rendement électrique du générateur et le meilleur rendement mécanique des pastilles, on cherche à faire fonctionner l'ensemble dans des conditions de résonance ou d'anti-résonnance électrique. En résonance, la tension et l'intensité du courant fourni par le générateur électrique sont en phase, et elles sont déphasées de 180° en anti-résonance. Pour simplifier, on utilisera par la suite l'expression "phase" pour désigner le déphasage entre tension et intensité, et "phase nulle" pour les deux cas de fonctionnement en phase (résonance) ou en opposition de phase (anti-résonance).

On sait que, d'après les caractéristiques propres des cristaux piézoélectriques, pour une tension déterminée, la meilleure amplitude de vibration est obtenue à la résonance, c'est à dire lorsque l'intensité est maximale. Mais pour une puissance déterminée, l'amplitude de vibration est meilleure à anti-résonance et, en conséquence, dans le cas où plusieurs actionneurs sont raccordés en parallèle sur le même générateur de puissance, on travaille en général à anti-résonance pour limiter la puissance nécessaire à fournir par le générateur électrique de puissance. Dans les deux cas, on cherche donc, pour optimiser le fonctionnement, à travailler à "phase" nulle ou minimale (c'est à dire à la résonance ou à anti-résonance).

Dans les conditions pratiques d'utilisation des pastilles piézoélectriques, la dite phase tend cependant à varier en fonction de l'environnement des pastilles et notamment en fonction de la puissance à transmettre, de la charge (donc des variations des conditions de fonctionnement des dispositifs auxquels sont transmises les vibrations), de la température, etc. Par exemple, dans le cas de la coulée continue d'acier dans une lingotière mise en vibration par ultra-sons (comme décrit par exemple dans les demandes de brevet français publiées sous les n° 2 570 626 et 2 648 063), les variations de flux de métal coulé ou d'échauffements, et les phénomènes d'accrochage de métal sur les parois de la lingotière créent des variations importantes et rapides de la charge mécanique sur les pastilles et donc de la charge électrique du générateur d'alimentation.

Il s'ensuit un déphasage et donc un éloignement de la phase de sa valeur de consigne F₀ qui, comme indiqué ci-dessus, est nulle.

Pour ramener la phase à sa valeur de consigne, il est connu d'insérer dans le circuit de commande des actionneurs un dispositif d'asservissement qui fait varier la fréquence de travail, autour d'une fréquence nominale f₀, en fonction de la valeur de phase mesurée, pour ramener celle-ci à la consigne F₀=0 qui correspond à un rendement optimal du système. La fréquence des vibrations est alors égale à la fréquence de résonance ou anti-résonance. La fréquence nominale f₀ est prédéterminée en fonction de l'application particulière considérée. Les systèmes d'asservissement connus sont des régulateurs analogiques de type PID (proportionnel intégral dérivé).De tels systèmes d'asservissement sont notamment connus par la demande de brevet français publiée sous le n° 2 640 173, qui décrit un système comportant notamment :
- un capteur de courant et un capteur de tension pour fournir des signaux représentatifs du courant et de la tension en sortie d'un oscillateur à fréquence commandée pilotant les actionneurs piézoélectriques,
- un comparateur de phase pour produire un signal représentatif du déphasage entre le courant et la tension,
- un circuit de commande de l'oscillateur pour commander la fréquence en fonction du déphasage, de manière à constamment ramener celui-ci vers la valeur nulle.

Le document EP-A-0217694 décrit également un procédé de ce type, dans lequel on modîfie la fréquence, en fonction d'un déphasage constaté et du sens de ce déphasage, dans le sens exigé par le dit sens du déphasage, jusqu'à ce que fa différence de phase disparaisse ou arrive à une valeur limite prédéterminée.

De même, le document EP 0662356 A décrit un procédé de ce type enseignant d'ajuster la fréquence à partir du déphasage courant-tension conjointement avec un autre paramètre électrique, tel que l'intensité du courant, ou la tension, ou la puissance.

Toutefois il a été constaté, notamment sur des installations industrielles de coulée continue, que de tels systèmes d'asservissement ne fonctionnaient pas toujours correctement, et nécessitaient parfois des interventions des opérateurs au cours de la coulée pour régler manuellement la fréquence, afin de rétablir un fonctionnement correct de l'installation. On a constaté que ces problèmes apparaissaient essentiellement lorsque plusieurs actionneurs étaient montés sur une même structure à mettre en vibration, telle que une lingotière de coulée continue, et en parallèle sur un même générateur ou oscillateur.

Des problèmes similaires existent pour d'autres applications des ultra-sons de puissance, lorsque la charge est variable.

La présente invention a pour but de résoudre les problèmes indiqués ci-dessus et vise en particulier à permettre un pilotage fiable d'actionneurs à ultra-sons de puissance permettant un fonctionnement optimal du système quelque soient les variations de charge. Elle vise également à fournir un dispositif de pilotage d'actionneurs à ultra-sons de puissance qui puisse être utilisé quelque soit l'application visée, et donc qui permette un pilotage fiable pour une large gamme de fréquences nominales et également quelque soit le nombre et la configuration des actionneurs utilisés.

Avec ces objectifs en vue, l'invention a pour objet un procédé de pilotage d'actionneurs à ultra-sons de puissance utilisés pour générer des ultra-sons de puissance dans une installation sidérurgique, dans lequel on règle la fréquence d'un oscillateur de pilotage desdits actionneurs en fonction de la phase entre la tension et l'intensité du signal fourni par ledit oscillateur, et, à cet effet,
- on détermine, avant la mise en service de l'installation, une fréquence nominale (f₀) du signal en fonction de la dite installation, et lors de la mise en service de l'installation :
- on mesure en permanence la dite phase,
- on définit un cycle d'échantillonnage de mesure ayant une période déterminée,
- on détermine le signe de la variation de la valeur absolue de la phase au cours de chaque période d'échantillonnage;
   procédé caractérisé en ce que,
- si la valeur absolue de la phase est égale ou supérieure à un premier seuil prédéterminé, on applique à la fréquence de l'oscillateur une correction de fréquence de même sens que la correction de fréquence appliquée précédemment si la variation de valeur absolue de la phase est négative, et de sens contraire si la variation de valeur absolue de la phase est positive, et si la variation de valeur absolue de la phase est nulle, on applique une correction de fréquence de signe aléatoire,
- et, selon que la valeur absolue de la phase est inférieure ou supérieure à un deuxième seuil prédeterminé, lesdites corrections en fréquence sont respectivement constantes ou croissantes en fonction de la phase.

Le procédé selon l'invention permet d'optimiser en permanence le fonctionnement du système en ajustant la fréquence de l'oscillateur de manière à minimiser en permanence la valeur absolue de la phase, quelques soient les configurations de actionneurs et les perturbations qui peuvent être produites lors du fonctionnement de l'installation mise en vibration.

Contrairement aux systèmes d'asservissement connus qui sont basés sur l'utilisation d'une boucle à verrouillage de phase et d'un régulateur de type PID, le procédé selon l'invention permet d'assurer un fonctionnement optimal quelques soient les caractéristiques de la structure vibrante et peut donc être utilisé pour des applications très diverses. De plus l'invention permet d'assurer un asservissement fiable de la fréquence à la phase, même lorsque les caractéristiques de l'installation et ses conditions d'exploitation conduisent à des variations très irrégulières ou brusques de la phase.

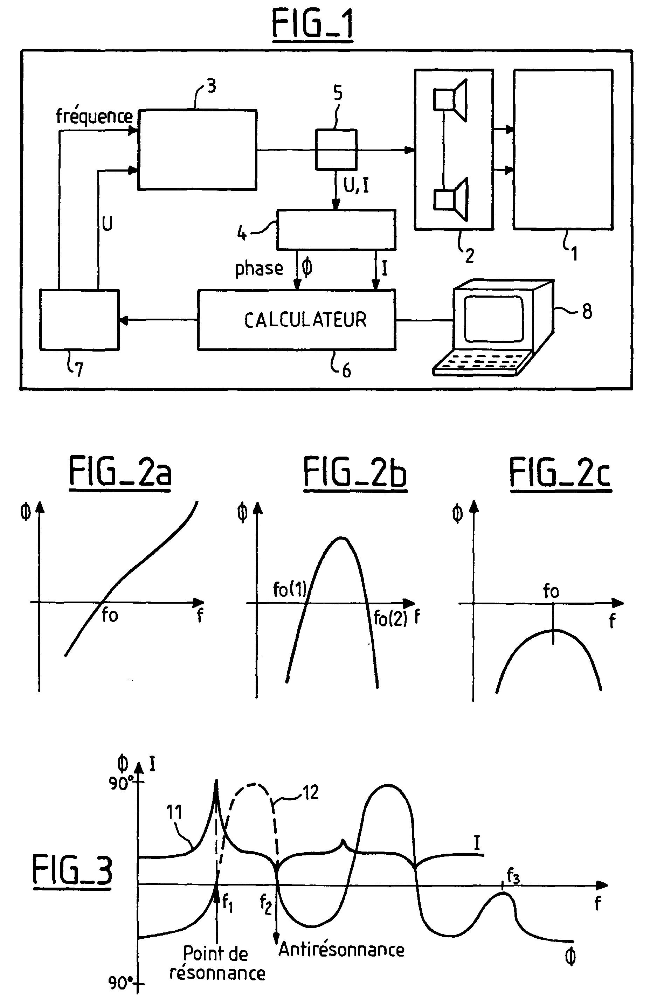

En effet, dans les systèmes d'asservissement classiques, basés sur la recherche d'une phase nulle correspondant à un fonctionnement en résonance ou en anti-résonance, on considère que, au voisinage de la fréquence optimale, la phase varie de manière continûment croissante en fonction de la fréquence réelle des vibrations ultrasonores, comme cela est représenté à la figure 2a qui représente la variation de la phase en fonction de la fréquence dans le cas d'un facteur de qualité apparent Q du montage piézoélectrique faible. L'asservissement consiste donc à comparer la valeur de la phase mesurée à une valeur de consigne (qui est classiquement F₀=0) et à ajuster la fréquence de l'oscillateur en fonction du résultat de cette comparaison pour ramener la phase à sa valeur de consigne. Un problème apparaît avec un tel système d'asservissement lorsque les caractéristiques de l'installation ou ses conditions d'exploitation font que la phase ne varie pas de manière continue en fonction de la fréquence. Un tel cas est illustré par la figure 2b qui représente la phase en fonction de la fréquence dans un montage avec un facteur de qualité Q élevé. De plus, et en particulier lorsque plusieurs actionneurs sont montés sur la même structure mécanique à faire vibrer, les courbes de réponse peuvent être très complexes, du fait que tous les actionneurs ne sont pas parfaitement identiques ou vieillissent de façon différente. Dans de tels cas, l'existence d'un point de fonctionnement à phase nulle, dans la plage de fréquence utile pour l'exploitation de l'installation, n'est pas assurée, (comme cela est illustré à la figure 2c que l'on verra par la suite).

En prenant ce dernier cas comme exemple, on comprendra aisément qu'un asservissement selon la technique antérieure ne peut fonctionner correctement puisqu'il existe deux points situés sur la courbe, de part et d'autre de la fréquence optimale f₀ pour lesquels la valeur de la phase est identique, et un tel système d'asservissement ne peut alors déterminer dans quel sens la fréquence doit être modifiée en réponse à une valeur de phase mesurée.

Ces problèmes expliquent les dysfonctionnements, constatés sur des installations industrielles utilisant une régulation de type PID, qui amenaient les opérateurs à intervenir manuellement pour corriger la fréquence de l'oscillateur.

Grâce au procédé selon l'invention, on s'affranchit de ces problèmes puisque la correction de fréquence apportée n'est pas en premier lieu fonction de la valeur de la phase mais du sens d'une variation de phase provoquée par une variation volontaire de la fréquence. Autrement dit, on regarde l'évolution de la phase pendant une période d'échantillonnage prédéterminée et, si la phase augmente, on fait varier la fréquence dans le sens inverse de la variation de fréquence qui a provoqué la dite variation de phase, et si la phase diminue, on continue à faire varier la fréquence dans le sens qui a conduit à cette diminution de phase.

Autrement dit, dans les procédés connus, on cherche toujours, en faisant varier la fréquence, à annuler le déphasage, ou au moins à le réduire, en considérant que le point de fonctionnement à déphasage nul existe et que le déphasage change de sens de part et d'autre de ce point. Ces procédés ne peuvent donc pas s'appliquer dans le cas de systèmes dont le fonctionnement correspond à la figure 2c. Contrairement à cela, dans le procédé selon l'invention, on cherche toujours à réduire ou annuler le déphasage, mais en se basant sur l'évolution constatée de celui-ci en réponse à une variation de fréquence appliquée précédemment, sans donc qu'il y ait besoin d'un point de fonctionnement à phase nulle et changement de sens du déphasage de part et d'autre du point de fonctionnement optimal.

Dans la mesure où la durée de la période d'échantillonnage est suffisante pour que l'évolution de la phase au cours d'une période soit représentative de l'effet provoqué par une variation de fréquence appliquée au début de cette période, c'est à dire que la période d'échantillonnage est supérieure au temps de réponse du système, on peut ainsi constater à la fin de cette période si la dite variation de fréquence est favorable ou non à une diminution de la valeur absolue de la phase, et ajuster, pour la période suivante, le sens de variation de la fréquence. On notera que cet ajustement est effectué sans besoin de connaître la valeur de la fréquence, et en particulier même si il n'existe pas, dans la fourchette de fréquences adaptée à l'application concernée, de point de fonctionnement à phase nulle.

Il peut arriver que la variation de phase détectée au cours d'une période d'échantillonnage soit nulle ou sensiblement nulle. Dans un tel cas, qui correspond en particulier à un point de fonctionnement du système à phase minimale (sommet de la courbe de la figure 2b), le système ne pouvant savoir quelle correction de fréquence à appliquer pourra avoir un effet bénéfique sur la diminution de la phase, on applique alors une correction de fréquence de signe aléatoire, et la variation de phase ainsi provoquée fera rentrer le système dans le mode de fonctionnement décrit précédemment.

Pour améliorer la dynamique du système, l'amplitude de la correction de fréquence appliquée est préférentiellement fonction de l'écart entre la valeur de la phase mesurée et la valeur de consigne F₀=0. Par exemple, si la dite phase est nulle ou inférieure à un premier seuil prédéterminé, la correction de fréquence est nulle. Si la dite phase est inférieure à un deuxième seuil prédéterminé, la correction de fréquence est constante. Et si la dite phase est supérieure au deuxième seuil prédéterminé, la correction de fréquence est croissante en fonction de la phase. Ceci étant, ces seuils pourront être fixés une fois pour toutes pour chaque application.

L'invention a aussi pour objet un dispositif de pilotage d'actionneurs à ultra-sons de puissance comportant les caractéristiques techniques données dans les revendications jointes relatives au dispositif.

D'autres caractéristiques et avantages apparaîtront dans la description qui va être faite, à titre d'exemple, de l'application de l'invention au pilotage de transducteurs utilisés pour générer des ultra-sons dans une lingotière de coulée continue d'acier.

On se reportera aux dessins annexés dans lesquels :
- la figure 1 est un schéma général de principe du système de génération des ultrasons;
- les figures 2a, 2b et 2c représentent trois cas typiques possibles de variation de la phase en fonction de la fréquence;
- la figure 3 est une représentation simplifiée des variations possibles de la phase et de l'intensité du courant fourni par l'oscillateur en fonction de la fréquence;
- la figure 4 est un organigramme de programmation du calculateur utilisé pour la mise en oeuvre de l'invention;
- la figure 5 représente la variation de la correction de fréquence appliquée à l'oscillateur en fonction de la valeur absolue de la phase.

Sur le dessin de la figure 1 sont représentés symboliquement la lingotière 1 et les actionneurs à ultra-sons 2, constitués, de manière connue en soi, par des éléments piézoélectriques fixés sur la lingotière et alimentés par un générateur électrique de puissance ou oscillateur 3. Il est à noter que, notamment dans cette application particulière mais aussi dans d'autres applications où la puissance de vibration à fournir est importante, on utilise classiquement plusieurs transducteurs, tels que des pastilles piézoélectriques, fixés sur la structure à mettre en vibration en différents endroits et alimentés en parallèle par le même générateur de puissance.

Un circuit d'interface de mesure 4 est relié à des moyens 5 de mesure de la tension et de l'intensité du courant fourni par le générateur de puissance. Ce circuit d'interface fournit à un calculateur 6 des signaux représentatif de l'intensité I et de la phase F entre la tension et le courant.

Le calculateur 6 est relié à un circuit d'interface de commande 7 qui pilote le générateur de puissance en lui fournissant des signaux de commande en fréquence et en tension.

Un clavier et un écran de visualisation 8 sont reliés au calculateur pour permettre à un opérateur de fixer les paramètres propres à l'installation et à son exploitation et commander l'initialisation, la mise ne service et l'arrêt du système, et pour visualiser l'état du système et fournir des alarmes en cas de dysfonctionnement.

La figure 3 montre de manière simplifiée, à titre explicatif, les variations de l'intensité du courant I (courbe 11) et de la phase F entre tension et courant (courbe 12) en fonction de la fréquence f des ultra-sons appliqués à une structure vibrante. A la fréquence f₁, correspondant à un fonctionnement en résonance, la phase F est nulle et le courant est maximal. A la fréquence f₂, correspondant à un fonctionnement en anti-résonance, la phase F est également nulle mais le courant est minimal. A la fréquence f₃ la valeur absolue de la phase présente un minimum. Dans la pratique, ces courbes peuvent être beaucoup plus complexes, les courbes de cette figure étant uniquement destinées à illustrer le fait que, en fonction de la fourchette de fréquence dans laquelle on souhaite faire vibrer la structure, il peut exister plusieurs fréquences auxquelles la phase est nulle, ou, à l'inverse, des gammes de fréquences où il n'est pas possible d'obtenir une phase nulle.

Par ailleurs, dans une installation industrielle telle que par exemple une lingotière de coulée continue, les caractéristiques vibratoires de la structure mise en vibration sont fortement variables dans le temps, ce qui a pour effet de modifier la fréquence de vibration optimale à chaque instant lors de l'exploitation de l'installation.

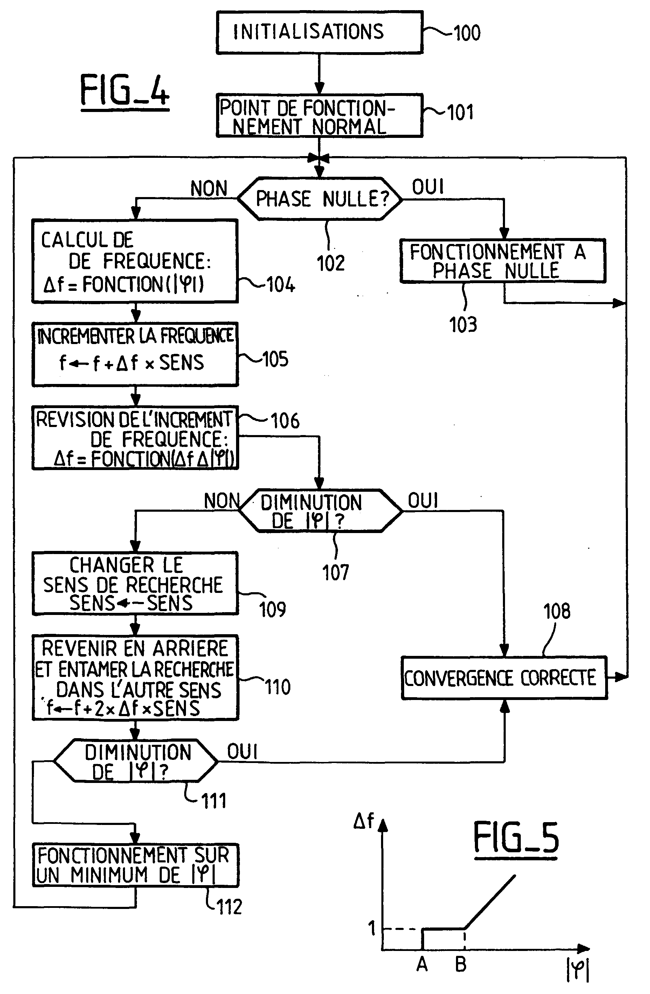

La figure 4 représente un organigramme de programmation du calculateur. Après la phase d'initialisation 100, qui permet de définir, comme on le verra par la suite, le point de fonctionnement normal 101 du système, la valeur de la phase est testée en 102. Si la phase est nulle, la fréquence f reste inchangée (fonctionnement à phase nulle 103). Si la phase n'est pas nulle, le calculateur calcule (étape 104) un incrément de fréquence Df fonction de la valeur absolue de la phase |F|, puis incrémente (étape 105) la fréquence de la valeur +Df ou -Df, puis révise l'incrément de fréquence en fonction de la variation de la valeur absolue de la phase (étape 106).

A l'étape 107, la variation de la valeur absolue de la phase |F| est testée. Si cette valeur diminue, le système constate en 108 une convergence correcte entre la variation de fréquence appliquée à l'étape 105 et l'évolution de la phase et revient au test 102 sur la valeur de la phase.

Si la valeur absolue de la phase augmente, le signe appliqué à l'incrément de fréquence est changé (étape 109) et la fréquence est incrémentée de 2.Df (étape 110), ce qui correspond à un retour en arrière sur l'axe des fréquences par rapport à la variation appliquée à l'étape 105. L'évolution de la valeur absolue de la phase est à nouveau testée (étape 111). Si cette valeur diminue, la convergence correcte entre la variation de fréquence appliquée et l'évolution de la phase est constatée. Sinon, cela signifie que quelque soit le sens de la variation de fréquence appliquée, la valeur absolue de la phase ne peut être réduite, et au constat 112 d'un fonctionnement sur un minimum de phase, et on revient au test 102 sur la valeur de la phase.

Le calcul de l'incrément de fréquence Df est effectué selon le graphique de la figure 5. On voit que si la valeur absolue de la phase |F| est inférieure à un premier seuil A prédéterminé, la valeur attribuée à Df est nulle. Si |F| est compris entre le premier seuil A et un second seuil B, la valeur attribuée à Df est constante. Et si |F| est supérieur au dit deuxième seuil B, la valeur attribuée à Df est croissante en fonction de |F|.

La mise en oeuvre du procédé selon l'invention dans une installation industrielle est effectuée en deux phases. La première phase est une phase d'initialisation et la deuxième phase est la phase d'asservissement proprement dite, qui s'effectue conformément au diagramme décrit ci-dessus, lors de l'exploitation de l'installation.

Dans le cas d'une lingotière de coulée continue, la gamme de fréquence utilisable est d'environ 10 kHz à 30 kHz. La phase d'initialisation a pour but de déterminer dans cette gamme la fréquence initiale f₀, correspondant à un fonctionnement optimal, en résonance ou en anti-résonance au choix de l'opérateur. Pour cela, une tension de consigne d'initialisation Uᵢ₀ est fixée, de valeur réduite par rapport à la tension nominale U₀ qui sera appliquée aux actionneurs lors de l'exploitation normale de l'installation, et un balayage en fréquence dans la gamme de fréquence prédéfinie est effectué. Au cours de ce balayage, l'intensité du courant et la phase sont mesurées. La fréquence initiale f₀ est déterminée, correspondant à un courant maximum pour une phase nulle si l'opérateur a choisi de travailler à la résonance, ou à un courant minimum pour une phase nulle s'il a choisi de travailler à anti-résonance. S'il n'y a pas de phase nulle dans la gamme de fréquences balayée, la fréquence f₀ retenue est celle où la valeur absolue de la phase est minimum.

Préférentiellement, un deuxième balayage en fréquence est effectué sur une plage de fréquence réduite, par exemple -500 Hz à +500 Hz autour de la fréquence prédéterminée, pour affiner le résultat.

L'opérateur a la possibilité de fixer, préalablement à l'initialisation, la gamme de fréquences, le type de recherche (résonance ou anti-résonance) et la tension utilisée pour cette recherche.

Après l'initialisation, la fréquence initiale f₀ est affichée sur. l'écran 8, et l'utilisateur peut également visualiser les courbes de phase et de courant en fonction de la fréquence, déterminer la pente de la courbe de phase au voisinage du point de fonctionnement sélectionné et visualiser les différentes fréquences fournissant une phase nulle avec les impédances correspondantes.

L'opérateur peut également régler la fréquence d'échantillonnage de l'asservissement, les valeurs de régulation (seuils A et B et gain) et la tension de consigne U₀ à utiliser en cours d'exploitation. La fréquence d'échantillonnage est choisie de manière que, comme déjà indiqué précédemment, la période d'échantillonnage soit supérieure au temps de réponse du système en boucle ouverte, tout en restant faible pour minimiser l'erreur de traînée. La fréquence d'échantillonnage pourra par exemple être de 100 Hz. En combinaison avec le choix de la fréquence d'échantillonnage, les valeurs de seuils et de gain peuvent être adaptées de manière à jouer sur la vitesse de réaction du système, c'est à dire la rapidité de variation de la fréquence, qui peut par exemple être de 10 à 100 Hz par seconde, en fonction de la pente de la courbe de phase au voisinage du point de fonctionnement optimal. Ces diverses possibilités de réglage permettent notamment d'utiliser le dispositif pour une très large gamme d'applications et quels que soient les actionneurs.

Après la phase d'initialisation, effectuée à puissance réduite sur l'installation avant le démarrage de la coulée, en appliquant aux actionneurs la tension d'initialisation Uᵢ₀, l'asservissement et la coulée sont démarrés et la montée en puissance des vibrations est effectuée en augmentant progressivement la tension U appliquée aux actionneurs jusqu'à sa valeur nominale d'exploitation U₀.

Au cours de l'asservissement, l'écran affiche diverses indications sur le fonctionnement du système, notamment une indication de fonctionnement à phase nulle ou à un minimum de valeur absolue de la phase, et des alarmes au cas ou la fréquence atteindrait les limites de la gamme de fréquence autorisée.

L'arrêt s'effectue en diminuant progressivement la tension appliquée aux actionneurs.

La vitesse de variation de la tension au démarrage et à l'arrêt de l'asservissement peut également être réglée. Pour limiter les variations de puissance, notamment lors du démarrage pour permettre à l'asservissement de maintenir la phase au minimum malgré les fortes variations de charge se produisant lors de la montée en puissance, on limitera la vitesse de variation de la tension, par exemple à U₀/10 volts par seconde. Il en sera de même lors de l'arrêt pour éviter un décrochage de l'asservissement avant l'arrêt complet des vibrations.

L'invention peut être facilement mise en oeuvre au moyen d'un micro-ordinateur programmé comme indiqué précédemment et équipé d'une carte d'acquisition, et de boîtiers d'interface entre l'ordinateur et les circuits de mesure et de puissance. Ces interfaces seront pourvus d'amplificateurs et transformateurs d'isolement de haute qualité pour éviter les parasites qui pourraient résulter de l'utilisation de tensions élevées, de l'ordre de 1000 V, pour l'alimentation des actionneurs.

L'utilisation d'un micro-ordinateur permet une grande souplesse d'utilisation. Le programme d'asservissement pourra cependant être aussi mis en oeuvre au moyens de circuits spécifiques selon les techniques connues en électronique.

La possibilité de régler les différents paramètres permet l'utilisation directe du dispositif selon l'invention pour de nombreuses applications industrielles, l'adaptation des caractéristiques d'asservissement aux divers types et configurations d'actionneurs utilisés dans ces diverses applications pouvant se faire automatiquement, par une procédure de calibrage.

En assurant un fonctionnement de l'installation industrielle et du générateur électrique de puissance dans des conditions optimales, quelque soit les caractéristiques vibratoires de l'installation et leurs variations en cours d'exploitation, la fiabilité du matériel utilisé et notamment celle des pastilles piézoélectriques est fortement améliorée.

Il est précisé que l'invention n'est pas d'application limitée aux émetteurs piezoélectriques.

Pour générer de la puissance ultrasonore, on peut également utiliser des émetteurs magnétostrictifs.

Le principe de fonctionnement à la résonance ou à l'anti-résonance est le même qu'avec les générateurs piezoélectriques. Simplement, le courant est alors prioritaire par rapport à la tension, alors qu'on est en situation contraire dans le cas de générateurs pizoélectriques.

## Revendications

1. Procédé de pilotage d'actionneurs à ultra-sons de puissance (2), utilisés pour générer des ultra-sons de puissance dans une installation sidérurgique (1), dans lequel on règle la fréquence d'un oscillateur (3) de pilotage desdits actionneurs en fonction de la phase (Φ) entre la tension et l'intensité du signal fourni par ledit oscillateur, et, à cet effet,
- on détermine, avant la mise en service de l'installation, une fréquence nominale (f₀) du signal en fonction de la dite installation, et lors de la mise en service de l'installation :
- on mesure en permanence la dite phase (Φ),
- on définit un cycle d'échantillonnage de mesure ayant une période déterminée,
- on détermine le signe de la variation de la valeur absolue (|Φ|) de la phase au cours de chaque période d'échantillonnage;
procédé caractérisé en ce que,
- si la valeur absolue (|Φ|) de la phase est égale ou supérieure à un premier seuil prédéterminé, on applique à la fréquence de l'oscillateur une correction de fréquence de même sens que la correction de fréquence appliquée précédemment si la variation de valeur absolue de la phase est négative, et de sens contraire si la variation de valeur absolue de la phase est positive, et si la variation de valeur absolue (|Φ|) de la phase est nulle, on applique une correction de fréquence de signe aléatoire,
- et, selon que la valeur absolue (|Φ|) de la phase est inférieure ou supérieure à un deuxième seuil prédeterminé, lesdites corrections en fréquence sont respectivement constantes ou croissantes en fonction de la phase (|Φ|).

2. Procédé selon la revendication 1, caractérisé en ce que la fréquence nominale (f₀) est déterminée dans une phase d'initialisation en effectuant un balayage en fréquence sous une tension de consigne initiale (Uᵢ₀) et en sélectionnant la fréquence pour laquelle la phase mesurée est nulle ou minimale et l'intensité du courant est minimale ou maximale.

## Claims

1. Method of driving power ultrasonic actuators (2), which are used to generate power ultrasound in a steel-manufacturing installation (1), in which the frequency of an oscillator (3) for driving the said actuators is adjusted as a function of the phase (Φ) between the voltage and the current strength of the signal supplied by the said oscillator, and, to this end,
- before putting the installation into service, a nominal frequency (f₀) of the signal is determined, depending on the said installation, and, when the installation is put into service:
- the said phase (Φ) is continuously measured,
- a measurement sampling cycle is defined having a determined period,
- the sign of the variation in the absolute value (|Φ|) of the phase is determined in the course of each sampling period;
which method is characterized in that,
- if the absolute value (|Φ|) of the phase is equal to or greater than a first predetermined threshold, a frequency correction is applied to the frequency of the oscillator, in the same direction as the frequency correction applied previously if the variation in absolute value of the phase is negative, and in the opposite direction if the variation in absolute value of the phase is positive, and, if the variation in absolute value (|Φ|) of the phase is zero, a frequency correction of random sign is applied,
- and, according to whether the absolute value (|Φ|) of the phase is less than or greater than a second predetermined threshold, the said frequency corrections are, respectively, constant or increasing, as a function of the phase (Φ).

2. Method according to Claim 1, characterized in that the nominal frequency (f₀) is determined in an initialization phase by carrying out a frequency scan at an initial datum voltage (Uᵢ₀) and by selecting the frequency for which the measured phase is zero or a minimum and the strength of the current is a minimum or maximum.

## Patentansprüche

1. Verfahren zur Ansteuerung von Leistungs-Ultraschallgebern (2) zur Erzeugung von Leistungsultraschall in einer Anlage der Eisen- und Stahlindustrie (1), wobei die Frequenz eines Oszillators (3) zur Ansteuerung dieser Geber als Funktion der Phase (Φ) zwischen der Spannung und der Stärke des von diesem Oszillator abgegebenen Signals gesteuert wird, indem
- vor der Inbetriebnahme der Anlage eine Nominalfrequenz (f₀) des Signals als Funktion dieser Anlage bestimmt wird und während des Betriebes der Anlage:
- permanent die Phase (Φ) gemessen wird,
- ein Eich-Meßzyklus mit einer bestimmten Periode festgelegt wird,
- das Vorzeichen der Variation des Absolutwertes (|Φ|) der Phase während jeder Eichperiode bestimmt wird,
- wobei das Verfahren dadurch gekennzeichnet, dass:
- wenn der Absolutwert (|Φ|) der Phase gleich einem oder größer als ein erster vorgegebener Schwellwert ist, die Frequenz des Oszillators mit einer Korrektur der Frequenz beaufschlagt wird in gleicher Richtung wie die vorherige Korrektur der Frequenz, wenn die Variation des Absolutwertes der Phase negativ ist, und in entgegengesetzter Richtung, wenn die Variation des Absolutwertes der Phase positiv ist, und dass, wenn die Variation des Absolutwertes (|Φ|) der Phase Null ist, eine Korrektur der Frequenz mit beliebigem Vorzeichen erfolgt, wobei
- je nachdem, ob der Absolutwert (|Φ|) der Phase kleiner oder größer als ein zweiter vorgegebener Schwellwert ist, die Korrektur der Frequenz konstant ist, bzw. als Funktion der Phase (Φ) ansteigt.

2. Verfahren nach Anspruch 1, dadurch gekennzeichnet, dass die Nominalfrequenz (f₀) festgelegt wird in einem Initialisierungsschritt, bei dem ein Frequenzhub durchgeführt wird, mit einer ursprünglichen Bezugsspannung Uᵢ₀ und durch Auswahl einer Frequenz für die die gemessene Phase Null oder minimal ist und die Stromstärke minimal oder maximal ist.
